# FASCICULE DE BREVET EUROPEEN

(11) **EP 2 920 828 B1**
(45) Date de publication et mention de la délivrance du brevet: **11.01.2017**
(21) Numéro de dépôt: 13789002.6
(22) Date de dépôt: 08.11.2013
(51) Int. Cl.: H01L 51/52, F21K 99/00, F21V 19/00, H01L 27/32, F21Y 105/00

(54) **CONNEXION ELECTRIQUE D'UN DISPOSITIF OLED**
ELEKTRISCHE VERBINDUNG EINER OLED-VORRICHTUNG
ELECTRICAL CONNECTION OF AN OLED DEVICE

(30) Priorité: 14.11.2012 FR 1260825
(43) Date de publication de la demande: 23.09.2015
(73) Titulaire: Astron Fiamm Safety, 83210 La Farlède (FR)
(72) Inventeur: KHALIFA, Mohamed, F-83160 La Valette du Var (FR); DUSSERT-VIDALET, Bruno, F-83130 La Garde (FR); MICHALCIK, Vincent, F-83000 Toulon (FR)
(74) Mandataire: Decobert, Jean-Pascal
(86) Numéro de dépôt international: PCT/EP2013/073440
(87) Numéro de publication internationale: WO 2014/076018

(56) Documents cités:
- EP-A2- 2 267 780
- EP-A2- 2 315 252
- WO-A1-2009/087585
- WO-A2-2008/012460
- JP-A- H10 199 673
- US-A1- 2006 043 912
- US-A1- 2010 046 210

## Description

### DOMAINE DE L'INVENTION

La présente invention est relative à la technologie OLED (En anglais : Organic Light-Emitting Diode), basée sur l'utilisation de diodes électroluminescentes organiques qui, une fois alimentées par un courant électrique, émettent leur propre lumière. La présente invention reçoit pour application avantageuse un procédé de fabrication d'un dispositif d'émission lumineuse organique.

La technologie OLED est particulièrement attrayante car permet la réalisation de dispositifs émissifs flexibles, à la fois légers, de faible épaisseur, consommant peu d'énergie, peu coûteux et aptes à couvrir une surface étendue.

### ARRIERE-PLAN TECHNOLOGIQUE

Le fonctionnement des OLEDs repose sur le phénomène d'électroluminescence, par lequel l'émission de la lumière résulte de l'action d'un champ électrique ou d'un courant passant à travers une substance donnée. Dans le cas des OLEDs, il s'agit de l'injection de charges électriques dans une couche de matière organique extrêmement fine (souvent d'environ 100 à 200 nanomètres). La lumière provient ainsi de l'émission d'un photon suscitée par la recombinaison d'un exciton (couple électron-trou), à l'intérieur de la couche émettrice en polymère.

Les recherches portant sur la production et la commercialisation de semiconducteurs organiques, se sont accélérées ces dernières années. Ces technologies, dans un premier temps destinées aux professionnels, trouvent aujourd'hui des applications de plus en plus nombreuses pour le grand public, notamment dans le domaine de l'éclairage domestique.

Grâce à leurs applications diverses, les dispositifs OLED devraient également profiter de l'évolution de l'électronique imprimée, qui est appelée à se développer fortement dans les prochaines années.

Les OLEDs pourraient se généraliser tant pour les petits écrans intégrés au sein des téléphones, automobiles, caméras, lecteurs MP3, que pour les écrans de télévision ou les panneaux d'affichage.

A ce jour, toutefois, la dégradation des dispositifs organiques reste particulièrement problématique. L'extrême sensibilité des matériaux organiques à la présence d'eau et d'oxygène contraint à une fabrication sous atmosphère inerte et à une encapsulation finale (comme tel est le cas pour les écrans OLED, par exemple).

Actuellement, l'alimentation des électrodes se fait au travers de parties non recouvertes par l'encapsulation de l'OLED, et induit donc des procédés de fabrication compliqués et, par conséquent, onéreux et sans garantie de parfaite étanchéité.

Plusieurs approches de connexion électrique sur des dispositifs d'émission lumineuse ont donc été envisagées. Parmi elles, une consiste à encapsuler l'empilement comprenant la couche organique au moyen d'un capot. Une couche métallique vient ensuite couvrir ledit capot, protégeant le système OLED d'éventuelles entrées d'eau et d'oxygène dans le système. Cette approche est évoquée dans la demande de brevet EP1120838A1. Pour cette approche, on utilise un second capot troué qui est apposé au dispositif OLED ; ledit dispositif OLED comprenant déjà un premier capot. Un inconvénient, découlant de cette étude, réside dans le contact de type mécanique existant entre le dispositif OLED encapsulé et le second capot, pouvant générer des défauts de contact. D'autre part, le procédé décrit est long, et le dispositif OLED final manque de compacité.

La présente invention permet de résoudre tout ou, du moins, une partie des inconvénients des techniques actuelles.

### RESUME DE L'INVENTION

La présente invention concerne notamment un procédé de fabrication d'un dispositif d'émission lumineuse organique de type OLED ; le procédé comprenant les séquences d'étapes suivantes:
- une étape de formation d'un empilement de couches sur un substrat ; ledit empilement comprenant, successivement et dans l'ordre, une première électrode déposée sur le substrat, une couche organique déposée au contact d'au moins une partie de la première électrode, une deuxième électrode déposée au contact d'au moins une partie de la couche organique ;
- une étape de mise en place d'un capot, dont une première face est encollée par une couche de colle, ledit capot se positionnant sur l'empilement de couches, de sorte que la couche de colle joint le capot et l'empilement de couches ;
- une étape de formation d'une plage de connexion, effectuée de sorte que la plage de connexion recouvre au moins une partie de la deuxième face du capot et au moins une partie d'une des électrodes ;
- une étape de fixation d'une première extrémité d'au moins un organe allongé de connexion électrique sur une zone de la plage de connexion recouvrant une partie de la deuxième face du capot ; caractérisé en ce qu'il comprend comme l'étape suivant la formation d'une couche de résine, ladite couche de résine étant configurée pour préserver un accès électrique à une deuxième extrémité de l'organe allongé de connexion électrique au dessus de la couche de résine.

La présente invention concerne également un dispositif d'émission lumineuse organique comprenant un empilement de couches sur un substrat; ledit empilement comprenant, successivement et dans l'ordre, une première électrode, une couche organique, une deuxième électrode, une couche de colle, un capot et une plage de connexion ; au moins un organe allongé de connexion électrique, dont une première extrémité est fixée sur une zone de la plage de connexion recouvrant une partie de la deuxième face du capot et une couche de résine étant configurée pour préserver un accès électrique à une deuxième extrémité d'au moins un organe allongé de connexion électrique au dessus de ladite couche de résine.

Ainsi, l'effet technique de la présente invention est de proposer une solution de parfaite étanchéité du dispositif OLED et une garantie de fiabilité concernant la connexion électrique. De cette manière, les couches présentes dans le dispositif d'émission lumineuse organique, connues pour être particulièrement sensibles au l'eau et à l'oxygène, sont parfaitement bien protégées par les moyens mis en oeuvre, et notamment par le système d'encapsulation grâce à la présence du capot.

L'invention est aussi relative à la formation d'une plage de connexion configurée de sorte à couvrir une large surface, et donc offrir l'avantage de pouvoir connecter au moins un organe allongé de connexion électrique, à n'importe quel endroit sur le capot.

L'invention permet de protéger non seulement les couches sensibles, mais également la connexion électrique grâce à la formation d'une couche de résine couvrant l'intégralité du volume du dispositif, connexion(s) électrique(s) comprise(s).

Un dispositif d'émission lumineuse organique et sa méthode de fabrication sont connus du document EP2315252.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- la figure 1 est une vue schématique en coupe longitudinale d'un l'empilement sur un substrat de différentes couches, contenues dans un dispositif de type OLED.
- La figure 2 schématise l'étape de mise en place d'un capot, préalablement encollé sur l'une de ses faces, recouvrant ledit empilement de couches.
- La figure 3 illustre la formation d'ouverture(s) d'accès sur l'empilement de couches, au terme de l'étape de mise en place du capot.
- La figure 4 illustre l'étape de formation de la plage de connexion recouvrant au moins une partie de la deuxième face du capot et au moins une partie d'une des électrodes.
- La figure 5 est une vue schématique partielle de dessus de la figure 4, représentant la plage de connexion recouvrant une partie du capot et les ouvertures d'accès.
- Les figures 6a et 6b illustrent les étapes de fixation d'une extrémité d'au moins un organe allongé de connexion électrique, réalisées par collage ou par soudure, respectivement.
- Les figures 7a et 7b illustrent l'étape de formation d'une couche de résine, configurée pour préserver un accès électrique à une deuxième extrémité d'un organe allongé de connexion électrique au dessus de ladite couche de résine

Par souci de clarté, les éléments sur les figures ne sont pas représentés à l'échelle.

### DESCRIPTION DETAILLEE

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Avant d'entrer dans le détail de formes préférées de réalisation de l'invention en référence aux dessins notamment, d'autres caractéristiques optionnelles de l'invention, qui peuvent être mises en oeuvre de façon combinée selon toutes combinaisons ou de manière alternative, sont indiquées ci-après :
- le procédé comprend une étape de fixation d'une première extrémité d'au moins un organe allongé de connexion électrique 600 sur une zone de la plage de connexion 500 recouvrant une partie de la deuxième face du capot 400.
- Le procédé comprend une étape de formation d'une couche de résine 700 ; ladite couche de résine 700 étant configurée pour préserver un accès électrique à une deuxième extrémité de l'organe allongé de connexion électrique 600 au dessus de la couche de résine 700.
- Le procédé comprend une étape de mise en place du capot 400, préservant une ouverture d'accès à au moins une des électrodes 210, 230; ledit capot 400 comportant au moins une ouverture.
- Le procédé comprend une étape de mise en place du capot 400, préservant une ouverture d'accès à au moins une deuxième électrode 210, 230; ledit capot 400 comportant au moins une deuxième ouverture.
- Le procédé comprend une étape de mise en place du capot 400 ; configurée de sorte à créer au moins deux ouvertures d'accès permettant d'encadrer et d'isoler la couche organique 220.
- Le procédé comprend une étape de fixation d'une première extrémité d'au moins un organe allongé de connexion électrique 600, réalisée par soudure.
- Le procédé comprend une étape de fixation d'une première extrémité d'au moins un organe allongé de connexion électrique 600, réalisée par collage.
- Le procédé selon l'invention comprend une étape de formation de la plage de connexion 500, caractérisée par une métallisation.
- Le procédé selon l'invention comprend une étape de formation de la plage de connexion 500, caractérisée en un dépôt sous vide.
- Le dispositif d'émission lumineuse organique comprend au moins un organe allongé de connexion électrique 600, dont une première extrémité est fixée sur une zone de la plage de connexion 500, recouvrant une partie de la deuxième face du capot 400.
- Le dispositif comprend une couche de résine 700 ; ladite couche de résine 700 étant configurée pour préserver un accès électrique à une deuxième extrémité d'au moins un organe allongé de connexion électrique 600 au dessus de la couche de résine 700.
- Le dispositif comprend un capot 400 comportant au moins une ouverture préservant un espace d'accès à au moins une des électrodes 210, 230.
- Le dispositif comprend un capot 400 comportant au moins une deuxième ouverture préservant un espace d'accès à au moins une deuxième électrode 210,230.
- Le dispositif comprend un capot 400 comportant au moins deux espaces d'accès remplis par la couche de résine 700 permettant d'encapsuler et protéger la première électrode 210, la couche organique 220 et la deuxième électrode 230.
- Le dispositif comprend une première extrémité d'au moins un organe allongé de connexion électrique 600, fixée par soudure ou par collage sur une partie de la plage de connexion 500.
- Le dispositif comprend un organe allongé de connexion électrique 600 ; organe mécaniquement conducteur de forme allongée, dont la largeur est de dimension négligeable par rapport à la longueur ; ledit organe pouvant être un fil électrique, une patte métallique ou encore une broche.
- Le dispositif comprend une plage de connexion 500 formée en un matériau choisi parmi le cuivre(Cu), l'aluminium (Al), l'argent (Ag), le chrome (Cr), le molybdène (Mo), le nickel (Ni), l'or (Au).
- Le dispositif comprend une plage de connexion 500 formée d'un empilement bicouche de matériaux choisis parmi les combinaisons : cuivre/aluminium, cuivre/argent, cuivre/molybdène, cuivre/chrome, cuivre/nickel, cuivre/or.
- Le dispositif comprend une plage de connexion 500 formée d'un empilement bicouche de matériaux dont les couches sont configurées de sorte à être superposées de manière totale ou partielle.

Ainsi, l'effet de l'invention a pour but de réaliser un dispositif d'émission lumineuse organique de type OLED, sur lequel est fixé au moins un organe allongé de connexion électrique, comprenant un élément électriquement conducteur et dont la dimension longue est supérieure à l'épaisseur et/ou la largeur.

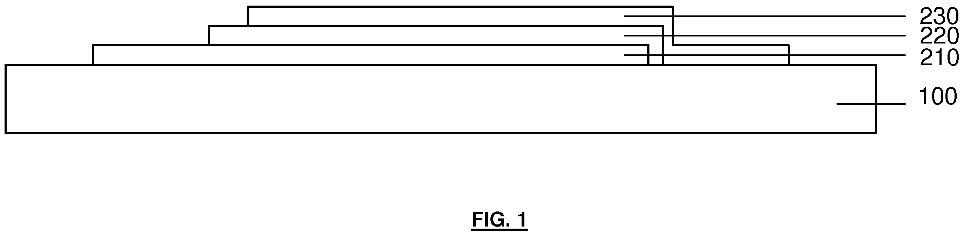

Dans une première étape, illustrée en **figure 1****,** on forme un empilement de couches 200 sur un substrat 100. De manière avantageuse, le substrat 100 est une plaque plane réalisée en un matériau transparent. Optionnellement, le substrat 100 est en verre.

Selon un mode de réalisation préférentiel, la couche organique 220 est avantageusement disposée de sorte à être insérée entre la première électrode 210 et la deuxième électrode 230.

La première électrode 210 est, de préférence, déposée sur le substrat 100. La couche organique 220 est avantageusement déposée de sorte à recouvrir une partie de la première électrode 210. Préférentiellement, la première électrode 210 dépasse latéralement de la couche organique 220. Avantageusement, la première électrode 210 présente une partie non recouverte par la couche organique 220. La deuxième électrode 230 est déposée de sorte à recouvrir au moins partiellement la couche organique 220. Préférentiellement, la deuxième électrode 230 recouvre la totalité de la surface de la couche organique 220, sans être en contact avec la première électrode 210. Préférentiellement, la deuxième électrode 230 s'étend au-delà de la couche organique 220 tel qu'illustré en figure 1. La deuxième électrode 230 dépasse latéralement de l'empilement de couches 200. La partie débordante de la première électrode 210 et la partie débordante de la deuxième électrode 230 ne sont ni superposées, ni en contact. Elles peuvent être situées sur des bordures opposées de l'empilement de couches 200.

Préférentiellement, la première électrode 210 constitue l'anode. La première électrode 210 est, typiquement, réalisée en un matériau métallique.

Selon un mode de réalisation où l'émission de la lumière se fait dans la direction opposée au substrat 100, la première électrode 210 est choisie en un matériau réfléchissant (voire semi-réfléchissant). La première électrode 210 peut être, par exemple, en aluminium.

Selon un mode de réalisation préférentiel où l'émission de la lumière se fait au travers du substrat 100, alors la première électrode 210 est choisie en un matériau transparent. De préférence, la première électrode 210 est composée par de l'oxyde d'indium dopé à l'étain (Indium Tin Oxide, ITO). Ce matériau possède des propriétés de conductivité électrique et une transparence optique intéressante pour la fabrication de dispositif d'émission lumineuse organique. Optionnellement, la première électrode 210 est transparente à au moins 85%, afin de permettre la transmission de la lumière.

La couche organique 220 est avantageusement composée d'une ou de plusieurs sous-couches. Ces sous-couches comprennent, de préférence, des matériaux spécifiques, permettant d'améliorer l'injection d'électrons et de trous, et par conséquent, d'améliorer l'efficacité du dispositif d'émission lumineuse. A titre d'exemple, la couche organique 220 peut notamment comprendre une couche d'injection des trous, une couche de transport des trous, une couche d'émission de la lumière produite par la recombinaison des trous et des électrons, une couche de transport des électrons et une couche d'injection des électrons.

La deuxième électrode 230 constitue généralement la cathode. Avantageusement, la deuxième électrode 230 est transparente. Optionnellement, elle est semi-transparente. La deuxième électrode 230 est, typiquement, réalisée en un matériau métallique. La deuxième électrode 230 peut, par exemple, être en un matériau tel que l'aluminium ou encore en calcium. Elle est, de préférence, déposée par évaporation thermique ou par pulvérisation cathodique.

Les épaisseurs de la première électrode 210, de la couche organique 220 et de la deuxième électrode 230, sont, avantageusement, comprises entre 10nm et 200nm.

Selon un mode de réalisation préférentiel, les conditions de dépôt des différentes couches se font sous une atmosphère contrôlée. La présence, en effet, d'impuretés dépend de l'atmosphère dans laquelle les structures sont fabriquées.

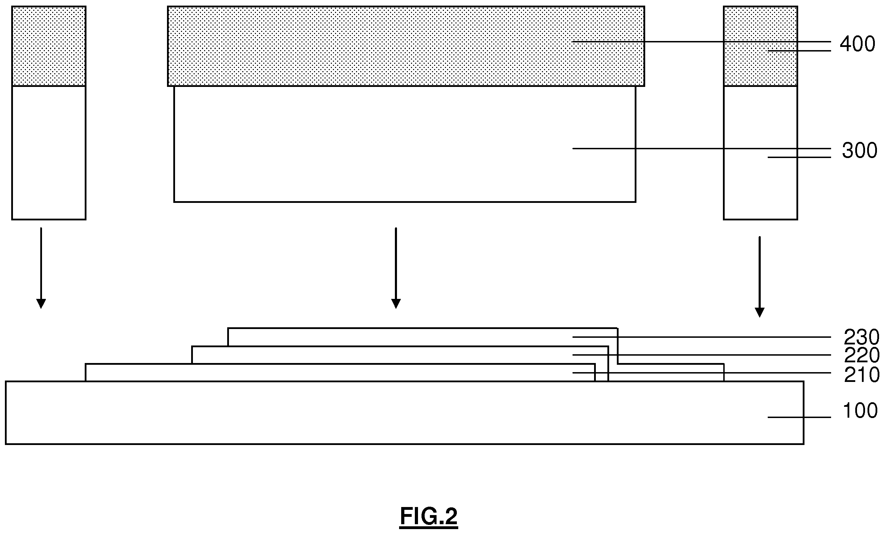

Tel qu'illustré **figure 2****,** il s'ensuit une étape de mise en place d'un capot 400 sur l'empilement de couches 200. Le capot 400 est, de préférence, enduit sur une première face d'une couche de colle 300, avant d'être déposé sur l'empilement de couches 200. La couche de colle 300 est, de préférence, étalée sur toute la surface du capot 400. Avantageusement, le capot 400 reçoit au préalable un nettoyage par traitement chimique, de sorte à ne pas introduire d'impuretés dans le système lors de sa mise en place. De préférence, le capot 400 est en un matériau transparent, configuré de sorte à laisser passer la lumière. Préférentiellement, le capot 400 est en verre. Optionnellement, le capot 400 peut être en matière plastique ou en métal. Selon un mode préférentiel, l'épaisseur du capot est d'environ 1 millimètre. De manière particulièrement avantageuse, le capot 400 peut être de formes diverses. A titre d'exemple, le capot 400 peut être prismatique, cylindrique ou cubique.

Avantageusement, le capot 400 présente au moins une ouverture configurée de sorte à être traversante. Préférentiellement, le capot 400 présente au moins une deuxième ouverture traversante. De manière particulièrement avantageuse, la section de l'ouverture dans le plan de l'OLED, perpendiculaire à l'épaisseur de l'OLED, peut prendre la forme d'un polygone, ou d'un oblong, par exemple.

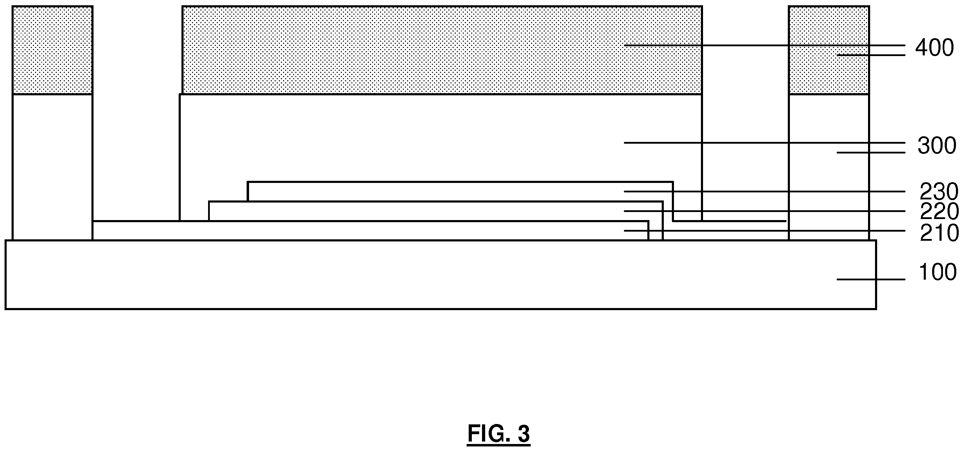

A l'issue de l'étape de mise en place du capot 400, tel qu'illustré sur la **figure 3****,** le capot 400 et la couche de colle 300 recouvrent l'empilement de couches 200.

De manière avantageuse, la couche de colle 300 recouvre la totalité de la couche organique 220. La couche de colle 300 est, de préférence, composée de résine époxy et présente une viscosité comprise entre 10 et 50000 mPa.s. La quantité de la couche de colle 300 nécessaire, est déterminée en fonction de la viscosité de la colle, et en fonction de l'épaisseur souhaitée de la couche de colle 300, après l'étape de mis en en place du capot 400.

La couche de colle 300 possède l'avantage, une fois sèche, de ne plus réagir avec l'eau, ni avec l'oxygène (premiers facteurs de dégradation des matériaux organiques). La couche de colle 300, ainsi disposée, agit, de manière particulièrement avantageuse, comme une barrière de protection étanche pour les couches sensibles telles que la première électrode 210, la couche organique 220 et la deuxième électrode 230.

Selon un mode de réalisation préférentiel, une zone de la partie débordante de la première électrode 210 et une zone de la partie débordante de la deuxième électrode 230 ne sont pas recouvertes (ni par la colle, ni par le capot). Avantageusement, au moins une ouverture dans le capot 400 est configurée de sorte à se positionner au droit d'une zone, non recouverte, de la partie débordante d'une des électrodes 210, 230.

De préférence, le capot 400 comporte au moins une ouverture, préservant un espace d'accès à au moins une des électrodes 210, 230. Avantageusement, le capot 400 comporte une deuxième ouverture préservant un espace d'accès à au moins une deuxième électrode 210, 230.

A titre préféré, la plus petite dimension d'une ouverture, et plus précisément sa largeur, est au moins 100 fois plus grande que l'épaisseur de l'empilement comprenant la première électrode 210, la couche organique 220, la deuxième électrode 230 et la couche de colle 300. Préférentiellement, le rapport des dimensions est d'au moins 1000. Par exemple, un tel empilement possède une épaisseur de l'ordre de 300 à 400 nm, alors qu'une ouverture possède une largeur minimale de 0.4 mm. Aussi, la couche de colle 300 ne s'étale pas sur le ou les espace(s) d'accès aux électrodes 210, 230. L'encapsulation obtenue est ainsi parfaitement réalisée et au moins une zone de la partie débordante d'une des électrodes 210, 230 est épargnée et ne reçoit pas, voire que partiellement, de la colle 300. Selon un mode de réalisation, une épaisseur de colle, comprise en 10 et 500 microns, permet d'obtenir une couche de colle 300 d'une épaisseur préférentiellement inférieure à 20 microns.

L'ouverture dans le capot 400 est configurée de sorte à se positionner au droit du bord de la partie débordante d'une des électrodes 210, 230, agissant ainsi comme une barrière de protection supplémentaire.

Selon un mode de réalisation non illustré, le capot 400 peut ne pas posséder d'ouverture. Dans ce cas, les dimensions et la forme du capot 400 sont configurées de sorte à préserver un espace d'accès à au moins une électrode 210, 230, au droit d'un des bords latéraux du capot 400.

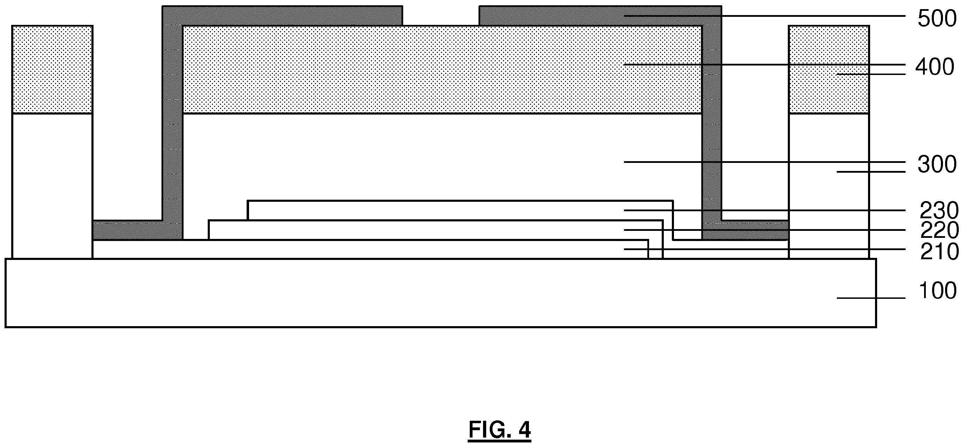

Une étape de formation d'une plage de connexion 500 est ensuite réalisée, comme représentée **figure 4****.**

Dans un mode de réalisation préférentiel, la plage de connexion 500 comprend :
- une première portion, parallèle au substrat 100, recouvrant la zone de la partie débordante d'une des électrodes 210, 230, non recouverte.
- une deuxième portion qui s'étend sur le bord selon l'épaisseur du capot 400.
- une troisième portion, recouvrant une partie de la face du capot 400 non recouverte par la couche de colle 300.

De manière avantageuse, la plage de connexion 500 est formée d'une couche de cuivre, d'aluminium, d'argent, de chrome, d'or, de molybdène, ou encore, de nickel.

Selon un mode de réalisation, la plage de connexion 500 comprend un empilement bicouche de matériaux choisis parmi les combinaisons : cuivre/aluminium, cuivre/argent, cuivre/molybdène, cuivre/chrome, cuivre/nickel, cuivre/or. Préférentiellement, la plage de connexion 500 comprend un empilement bicouche de matériaux dont les couches sont configurées de sorte à être superposées de manière partielle ou totale.

Avantageusement, la plage de connexion 500 réside en une déposition sous vide. Elle peut être déposée, de préférence, par évaporation thermique. Selon une variante, elle peut également être déposée par pulvérisation cathodique.

La méthode de déposition sous vide de la plage de connexion 500 possède l'avantage de ne pas chauffer le substrat 400 qui reste à une température inférieure à 40°C, grâce au vide créé. Cette méthode est donc peu coûteuse en énergie. Avantageusement, le vide ambiant permet d'assurer la pureté du dépôt, et par conséquent d'éviter l'incorporation d'impuretés notamment dans l'empilement de couches 200 ; ledit empilement comprenant des couches sensibles telles que la couche organique 220, la première électrode 210 et la deuxième électrode 230.

Selon un mode de réalisation préférentiel, le dépôt sous vide permet d'obtenir une couche mince de la plage de connexion 500, d'épaisseur comprise entre quelques nanomètres et quelques microns (par exemple, entre 50 nanomètres et 5 microns).

De manière particulièrement avantageuse, une épaisseur de la plage de connexion 500 de 1 micron est suffisante pour une épaisseur du capot 400 de 1 millimètre.

Avantageusement, la plage de connexion 500 recouvre totalement les ouvertures d'accès, protégeant ainsi la couche organique 220 contre de potentielles entrées d'eau et d'oxygène.

Préférentiellement, la plage de connexion 500 est formée sous une atmosphère inerte. Elle a pour avantage d'encapsuler le ou les espace(s) d'accès aux électrodes 210, 230 sans risque de résidu d'oxygène et d'eau.

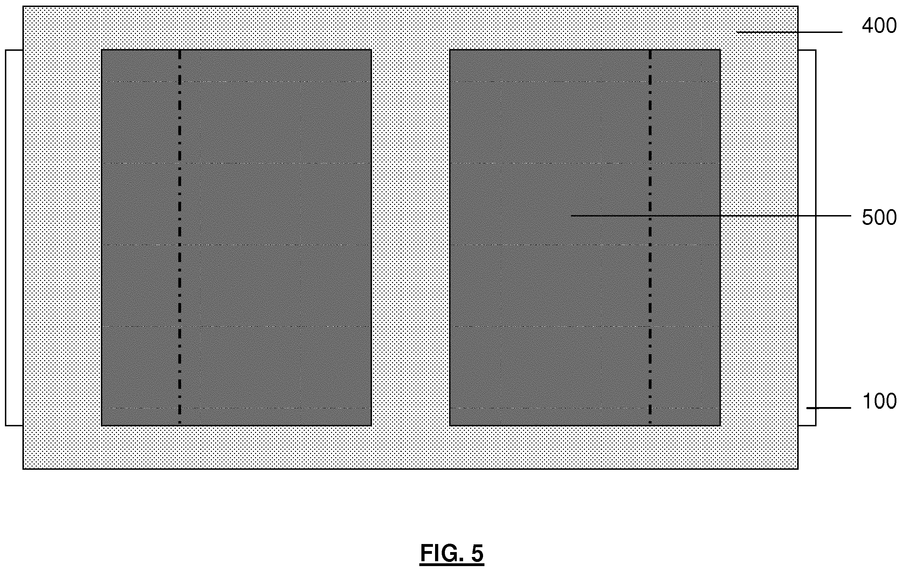

Une vue schématique partielle de dessus de la **figure 4****,** est représentée **figure 5****.** La plage de connexion 500 recouvre, de préférence, une partie du capot 400 et au moins un espace d'accès aux électrodes 210, 230.

De manière particulièrement avantageuse, il devient possible de connecter au moins un organe allongé de connexion électrique 600 à n'importe quel endroit sur le capot 400 recouvert par la plage de connexion 500, et particulièrement dans des zones très éloignées, voire extérieures aux espaces d'accès aux électrodes 210, 230.

De manière particulièrement avantageuse, la méthode de déposition sous vide de la plage de connexion 500 permet une bonne adhérence du métal sur le substrat 100.

De préférence, la déposition de la plage de connexion 500 au contact de la première électrode 210 et la déposition de la plage de connexion 500 au contact de la deuxième électrode 230, sont faites de manière à être convergentes. Avantageusement, le bord de la plage de connexion 500 au contact de la première électrode 210 est espacé du bord de la plage de connexion 500 au contact de la deuxième électrode 230, de quelques nanomètres.

Avantageusement, la plage de connexion 500 est configurée de sorte à offrir une grande liberté en terme de position et de nature du ou des organes allongé(s) de connexion électrique 600. La plage de connexion 500 possède, en effet, les avantages d'une faible épaisseur (d'environ 1 micron) et d'une tenue mécanique suffisante pour parfaitement suivre la topographie du capot 400. Il s'ensuit une conductivité uniforme et inaltérée.

La partie débordante de la première électrode 210 permet un accès électrique par la partie supérieure du dispositif, et plus précisément par le capot.

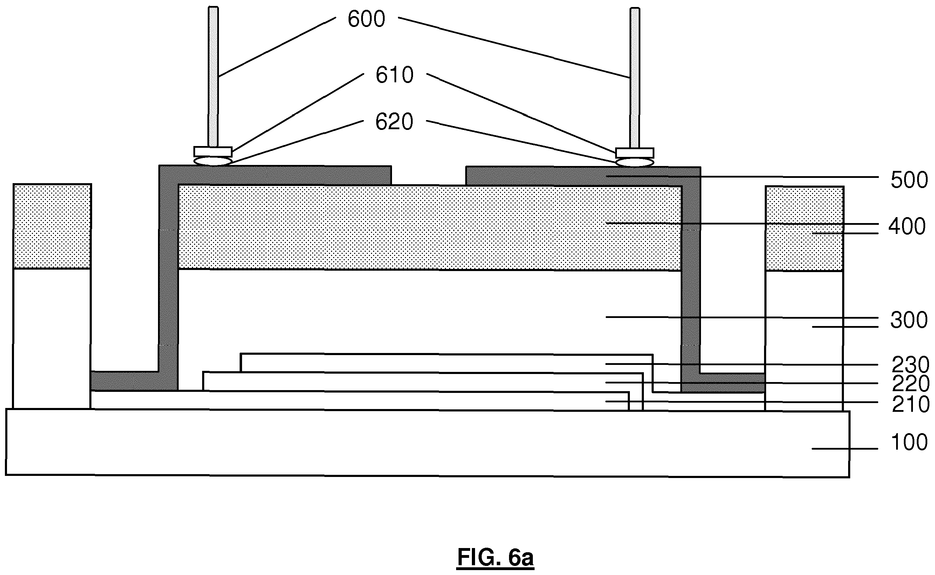

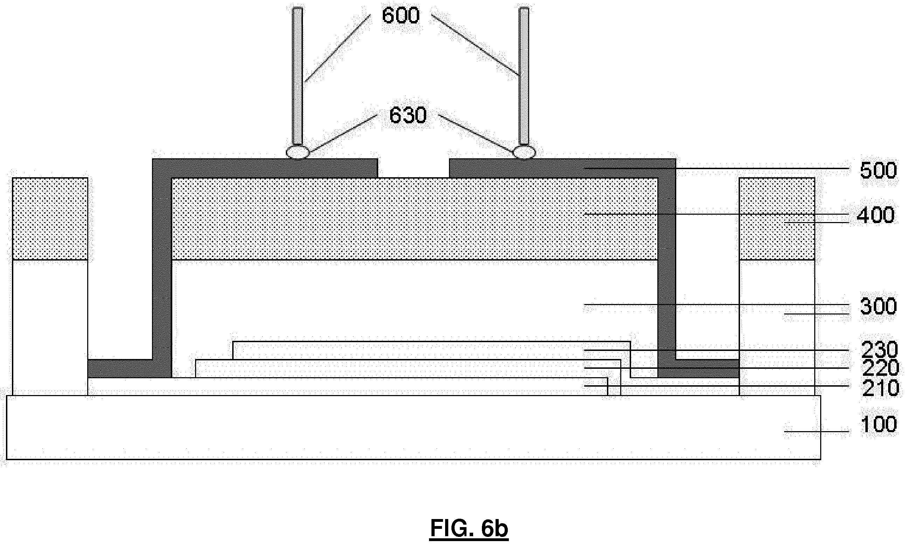

Les étapes de fixation d'au moins un organe allongé de connexion électrique sont illustrées en **figures 6a** **et** **6b****.**

De préférence, l'organe allongé de connexion électrique 600 est un organe électriquement conducteur de forme allongée, dont au moins une dimension longitudinale est au moins 5 fois supérieure à l'épaisseur transversale. Avantageusement, l'organe allongé de connexion électrique 600 peut être un fil électrique, une patte métallique ou encore une broche.

De manière particulièrement avantageuse, une première extrémité d'un organe allongé de connexion électrique 600 peut être fixée sur la plage de connexion 500 par soudure ou brasure. De préférence, une des extrémités d'un organe allongé de connexion électrique est fixée directement sur la plage de connexion 500 au moyen d'étain 630. On entend par extrémité une partie située à une bordure extrême de l'organe allongé selon une direction longitudinale.

Selon une variante, une première extrémité d'un organe allongé de connexion électrique 600 peut également être fixée sur la plage de connexion 500 par collage. Préférentiellement, une des extrémités d'un organe allongé de connexion électrique est collée sur la plage de connexion 500 au moyen de patch en laiton 610 et de pâte conductrice 620. La pâte conductrice 620 est, de préférence, de la laque d'argent. La laque d'argent, de manière avantageuse, évite un échauffement localisé à l'endroit de la soudure.

Selon un mode de réalisation préférentiel, un organe allongé de connexion électrique 600 connecté à la première électrode 210, soit l'anode peut être fixé à proximité d'un organe allongé de connexion électrique 600 connecté à la deuxième électrode 230, soit la cathode.

De manière particulièrement avantageuse, une soudure ou un adhésif conducteur élémentaire suffira pour réaliser le contact électrique loin des ouvertures d'accès.

De manière particulièrement avantageuse, le procédé peut éviter les traitements thermiques, pouvant être localisés à proximité d'au moins une des électrodes 210, 230 et/ou de la couche organique 220.

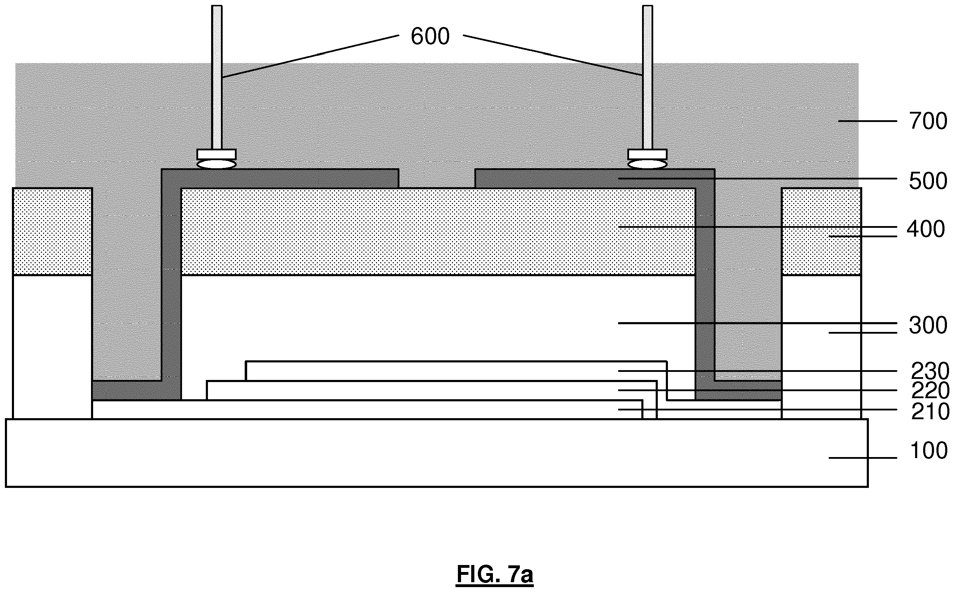

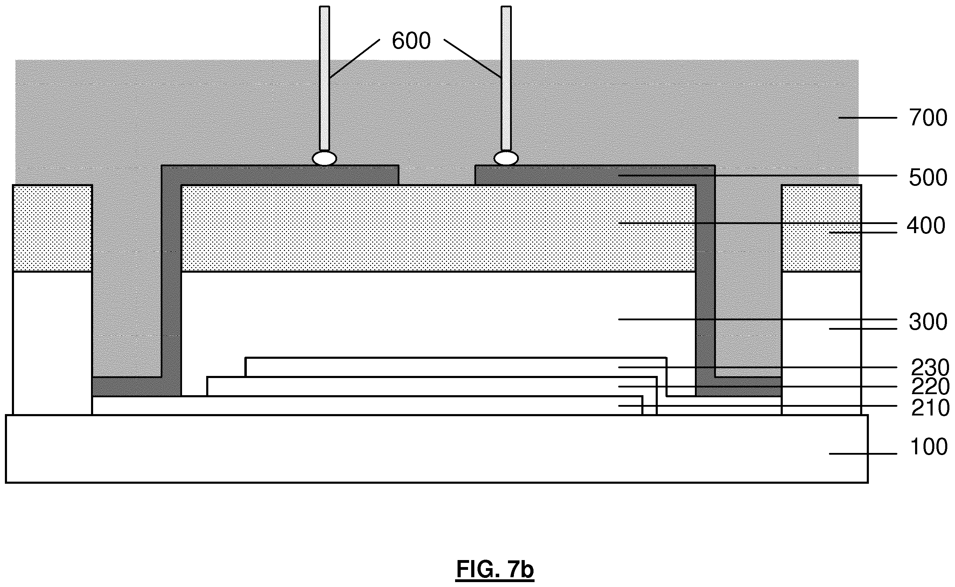

Une étape de formation d'une couche de résine 700 est illustrée en **figures 7a** **et** **7b****.** Avantageusement, la couche de résine 700 recouvre la totalité du dispositif OLED, de sorte à encapsuler et protéger la couche organique 220 et les électrodes 210, 230. La couche de résine 700, de manière avantageuse, remplit les espaces d'accès aux électrodes 210, 230.

La couche de résine 700, ainsi disposée, agit, de manière particulièrement avantageuse, comme une barrière de protection étanche pour les couches sensibles telles que la première électrode 210, la couche organique 220 et la deuxième électrode 230.

De manière particulièrement avantageuse, la couche de résine 700 est configurée pour préserver un accès électrique à une deuxième extrémité d'un organe allongé de connexion électrique 600, au dessus de ladite couche de résine 700.

La couche de résine 700 permet, de manière avantageuse, de protéger et renforcer la fixation sur la plage de connexion 500, d'un au moins des organes allongés de connexion électrique 600.

La présente invention propose ainsi un procédé particulièrement simple, rapide et fiable pour obtenir un dispositif d'émission lumineuse organique possédant au moins un organe allongé de connexion électrique 600.

De préférence, le dispositif OLED encapsulé est compatible avec les exigences industrielles, également pour de grandes surfaces.

### REFERENCES

- 100.: Substrat
- 200.: Empilement de couches
- 210.: Première électrode
- 220.: Couche organique
- 230.: Deuxième électrode
- 300.: Couche de colle
- 400.: Capot
- 500.: Plage de connexion
- 600.: Organe allongé de connexion électrique
- 610.: Patch en laiton
- 620.: Pâte conductrice
- 630.: Etain
- 700.: Couche de résine

## Revendications

1. Procédé de fabrication d'un dispositif d'émission lumineuse organique de type OLED, le procédé comprenant les séquences d'étapes suivantes:
- une étape de formation d'un empilement de couches (200) sur un substrat (100); ledit empilement comprenant, successivement et dans l'ordre, une première électrode (210) déposée sur le substrat (100), une couche organique (220) déposée au contact d'au moins une partie de la première électrode (210), une deuxième électrode (230) déposée au contact d'au moins une partie de la couche organique (220),
- une étape de mise en place d'un capot (400), dont une première face est encollée par une couche de colle (300), ledit capot se positionnant sur l'empilement de couches (200), de sorte que la couche de colle (300) joint le capot (400) et l'empilement de couches (200),
- une étape de formation d'une plage de connexion (500) effectuée de sorte que la plage de connexion (500) recouvre au moins une partie de la deuxième face du capot (400) et au moins une partie d'une des électrodes (210, 230),
- une étape de fixation d'une première extrémité d'au moins un organe allongé de connexion électrique (600) sur une zone de la plage de connexion (500) recouvrant une partie de la deuxième face du capot (400),
**caractérisé en ce qu'**il comprend comme étape suivante la formation d'une couche de résine (700), recouvrant la totalité du dispositif OLED ; ladite couche de résine (700) étant configurée pour préserver un accès électrique à une deuxième extrémité de l'organe allongé de connexion électrique (600) au dessus de la couche de résine (700).

2. Procédé selon la revendication précédente dans lequel l'étape de mise en place du capot (400) est configurée pour préserver un espace d'accès à au moins une des électrodes (210, 230); ledit capot (400) comportant au moins une ouverture.

3. Procédé selon l'une des revendications précédentes dans lequel l'étape de mise en place du capot (400) est configurée pour préserver un espace d'accès à au moins une deuxième électrode (210, 230); ledit capot (400) comportant au moins une deuxième ouverture.

4. Procédé selon l'une des revendications précédentes dans lequel l'étape de mise en place du capot (400), créant au moins deux espaces d'accès, est configurée de sorte à encadrer la couche organique (220) tout en préservant l'isolation grâce à la couche de résine (700).

5. Procédé selon l'une des revendications précédentes dans lequel l'étape de fixation d'une première extrémité d'au moins un organe allongé de connexion électrique (600) comprend une soudure et/ou un collage.

6. Procédé selon l'une des revendications précédentes dans lequel l'organe allongé de connexion électrique (600) est un organe électriquement conducteur de forme allongée, choisi parmi un fil électrique, une patte métallique ou encore une broche.

7. Procédé selon l'une des revendications précédentes dans lequel l'étape de formation de la plage de connexion (500) comprend une métallisation et/ou un dépôt sous vide.

8. Dispositif d'émission lumineuse organique comprenant un empilement de couches (200) sur un substrat (100) ; ledit empilement comprenant, successivement et dans l'ordre, une première électrode (210), une couche organique (220), une deuxième électrode (230), une couche de colle (300), un capot (400) et une plage de connexion (500) ; ladite plage de connexion (500) comprenant une première portion parallèle au substrat (100), recouvrant la zone de la partie débordante d'une des électrodes (210), (230), non recouverte, une deuxième portion qui s'étend sur le bord selon l'épaisseur du capot (400) et une troisième portion, recouvrant une partie de la face du capot (400) non recouverte par la couche de colle (300),
au moins un organe allongé de connexion électrique (600), dont une première extrémité est fixée sur une zone de la plage de connexion (500) recouvrant une partie de la deuxième face du capot (400),
**caractérisé en ce que** le dispositif comprend également une couche de résine (700) recouvrant la totalité de l'empilement et remplissant le ou les espace(s) d'accès à au moins une des électrodes (210), (230); ladite couche de résine (700) étant configurée pour préserver un accès électrique à une deuxième extrémité d'au moins un organe allongé de connexion électrique (600) au dessus de la couche de résine (700).

9. Dispositif selon la revendication précédente dans lequel le capot (400) comporte au moins une ouverture préservant un espace d'accès à au moins une des électrodes (210, 230).

10. Dispositif selon l'une des deux revendications précédentes dans lequel le capot (400) comporte au moins une deuxième ouverture préservant un espace d'accès à au moins une deuxième électrode (210, 230).

11. Dispositif selon l'une des deux revendications précédentes dans lequel le capot (400) comporte au moins deux espaces d'accès remplis par la couche de résine (700) permettant d'encapsuler et protéger la première électrode (210), la couche organique (220) et la deuxième électrode (230).

12. Dispositif selon l'une des quatre revendications précédentes dans lequel une première extrémité d' au moins un organe allongé de connexion électrique (600) est fixée par soudure ou par collage sur une partie de la plage de connexion (500).

13. Dispositif selon l'une des cinq revendications précédentes dans lequel l'organe allongé de connexion électrique (600) est un organe électriquement conducteur de forme allongée, choisi parmi un fil électrique, une patte métallique ou encore une broche.

14. Dispositif selon l'une des six revendications précédentes dans lequel la plage de connexion (500) est en un matériau choisi parmi le cuivre (Cu), l'aluminium (Al), l'argent (Ag), le chrome (Cr), le molybdène (Mo), le nickel (Ni), l'or (Au).

15. Dispositif selon les revendications 9 à 13 dans lequel la plage de connexion (500) comprend un empilement bicouche de matériaux choisis parmi les combinaisons : cuivre/aluminium, cuivre/argent, cuivre/molybdène, cuivre/chrome, cuivre/nickel, cuivre/or et/ou dans lequel la plage de connexion (500) comprend un empilement bicouche de matériaux dont les couches sont configurées de sorte à être superposées de manière totale ou partielle.

## Patentansprüche

1. Verfahren zur Herstellung einer Vorrichtung für eine organische Leuchtdiode bzw. eine OLED-Vorrichtung, wobei das Verfahren die folgenden Schritte umfasst:
- die Bildung einer Schichtung (200) auf einem Substrat (100), wobei besagte Schichtung nacheinander in der genannten Reihenfolge eine erste, auf dem Substrat (100) aufgetragene Elektrode (210) umfasst,, eine zweite organische Schicht (220), die in Kontakt mit mindestens einem Teil der ersten Elektrode (210) aufgetragen wurde, und eine zweite Elektrode (230), die im Kontakt mit mindesten einem Teil der organischen Schicht (220) aufgetragen wurde,
- das Aufsetzen einer Abdeckung (400), von der eine erste Seite durch eine Schicht Klebstoff (300) aufgeklebt wird, wobei besagte Abdeckung auf der Schichtung (200) so angebracht ist, dass sich die Schicht Klebstoff (300) mit der Abdeckung (400) und der Schichtung (200) verbindet.
- die Bildung einer Anschlussfläche (500), die so hergestellt wird, dass die Anschlussfläche (500) mindestens einen Teil der zweiten Seite der Abdeckung (400) und mindestens einen Teil einer der Elektroden (210, 230) abdeckt.
- die Befestigung eines ersten Endes mindestens eines länglichen elektrischen Verbindungselements (600) an einem Bereich des Anschlussfläche (500), welcher zum Teil die zweite Seite der Abdeckung (400) abdeckt,
**dadurch gekennzeichnet, dass** es als nächsten Schritt
- die Bildung einer Harzschicht (700) umfasst, welche die gesamte OLED-Vorrichtung bedeckt, wobei besagte Harzschicht (700) so gestaltet ist, dass der elektrische Zugang zu einem zweiten Ende des länglichen elektrischen Verbindungselements (600) auf der Harzschicht (700) aufrecht erhalten wird.

2. Verfahren nach dem vorhergehenden Anspruch, in dem das Auflegen der Abdeckung (400) so erfolgt, dass ein Zugangsbereich zu mindestens einem der Elektroden (210, 230) aufrecht erhalten wird, wobei besagte Abdeckung (400) mindestens eine Öffnung enthält.

3. Verfahren nach einem der vorhergehenden Ansprüche, in dem das Auflegen der Abdeckung (400) so erfolgt, dass ein Zugangsbereich zu mindestens einer zweiten Elektrode (210, 230) aufrecht erhalten wird, wobei besagte Abdeckung (400) mindestens eine zweite Öffnung umfasst.

4. Verfahren nach einem der vorhergehenden Ansprüche, in dem das Auflegen der Abdeckung (400), bei dem mindestens zwei Zugangsbereiche entstehen, so erfolgt, dass die organische Schicht (220) eingerahmt und gleichzeitig die Isolierung durch die Harzschicht (700) aufrecht erhalten wird.

5. Verfahren nach einem der vorhergehenden Ansprüche, in dem ein erstes Ende mindestens eines länglichen elektrischen Verbindungselements (600) durch Schweißung und oder Verklebung befestigt wird.

6. Verfahren nach einem der vorhergehenden Ansprüche, in dem das längliche elektrische Verbindungselement (600) ein elektrisch leitendes Element in länglicher Form ist, das ein elektrischer Draht, ein metallischer Bügel oder ein Stift sein kann.

7. Verfahren nach einem der vorhergehenden Ansprüche, in dem die Bildung der Anschlussfläche (500) die Vakuummetallisierung und/oder Vakuumbeschichtung umfasst.

8. Vorrichtung für eine organische Leuchtdiode, welche eine Schichtung (200) auf einem Substrat (100) umfasst, wobei besagte Schichtung nacheinander, in der genannten Reihenfolge eine erste Elektrode (210), eine organische Schicht (220), eine zweite Elektrode (230), eine Klebstoffschicht (300), eine Abdeckung (400) und eine Anschlussfläche (500) umfasst, wobei besagte Anschlussfläche (500) einen ersten Abschnitt umfasst, der parallel zum Substrat (100) verläuft und den nicht bedeckten Bereich des überstehenden Teils einer der Elektroden (210, 230) überdeckt, einen zweiten Abschnitt, der sich am Rand über die Dicke der Abdeckung (400) erstreckt, und einen dritten Abschnitt, der einen Teil der Seite der Abdeckung bedeckt (400), die nicht mit der Klebstoffschicht (300) bedeckt ist,
- mindestens ein längliches elektrisches Verbindungselement (600), dessen erstes Ende in einem Bereich der Anschlussfläche (500) befestigt ist, der einen Teil der zweiten Seite der Abdeckung (400) abdeckt,
**dadurch gekennzeichnet, dass** besagte Vorrichtung darüber hinaus eine Harzschicht (700) aufweist, welche die gesamte Schichtung bedeckt und den oder die Zugangsbereiche zu mindestens einer der Elektroden (210, 230) füllt, wobei besagte Harzschicht (700) so gestaltet ist, dass ein elektrischer Zugang zu einem zweiten Ende mindestens eines länglichen elektrischen Verbindungselements (600) auf der Harzschicht (700) aufrecht erhalten wird.

9. Vorrichtung nach dem vorhergehenden Anspruch, in dem die Abdeckung (400) mindestens eine Öffnung enthält, die einen Zugangsbereich zu mindestens einer der Elektroden (210, 230) aufrecht erhält.

10. Vorrichtung nach einem der beiden vorhergehenden Ansprüche, in welcher die Abdeckung (400) mindestens eine zweite Öffnung umfasst, welche einen Zugangsbereich zu mindestens einer zweiten Elektrode (210, 230) aufrecht erhält.

11. Vorrichtung nach einem der beiden vorhergehenden Ansprüche, in dem die Abdeckung (400) mindestens zwei Zugangsbereiche umfasst, die mit der Harzschicht (700) gefüllt sind, so dass die erste Elektrode (210), die organische Schicht (220) und die zweite Elektrode (230) umhüllt und geschützt sind.

12. Vorrichtung nach einem der vier vorhergehenden Ansprüche, in der ein erstes Ende mindestens eines länglichen elektrischen Verbindungselements (600) durch Schweißung oder Verkleben an einem Teil der Anschlussfläche (500) befestigt wird.

13. Vorrichtung nach einem der fünf vorhergehenden Ansprüche, in der das längliche, elektrische Verbindungselement (600) ein elektrisch leitendes Element ist, das ein elektrischer Draht, ein metallischer Bügel oder ein Stift sein kann.

14. Vorrichtung nach einem der sechs vorhergehenden Ansprüche, in dem die Anschlussfläche (500) aus einem Material besteht, das Kupfer (Cu), Aluminium (AI), Silber (Ag), Chrom (Cr), Molybdän (Mo), Nickel (NI) und Gold (Au) sein kann.

15. Vorrichtung nach den Ansprüchen 9 bis 13, in der die Anschlussfläche (500) eine zweischichtige Struktur aus Materialien enthält, die aus folgenden Kombinationen ausgewählt werden: Kupfer/Aluminium, Kupfer/Silber, Kupfer/Molybdän, Kupfer/Chrom, Kupfer/Nickel, Kupfer/Gold und/oder bei der die Anschlussfläche (500) eine zweischichtige Struktur aus Materialien umfasst, deren Schichten so angeordnet sind, dass sie ganz oder teilweise überlagert sind.

## Claims

1. A method for manufacturing an organic light emitting device, the method comprising the following sequences of steps:
- a step of forming a stack of layers (200) on a substrate (100), said stack comprising, successively, a first electrode (210) positioned on the substrate (100), an organic layer (220) positioned in contact with at least a portion of the first electrode (210), a second electrode (230) positioned in contact with at least a portion of the organic layer (220),
- a step of positioning a cover (400), a first face of which is bonded using an adhesive layer (300), with said cover being positioned on the stack of layers (200), so that the adhesive layer (300) fits the cover (400) and the stack of layers (200),
- a step of forming a connection pad (500) so executed that the connection pad (500) covers at least a portion of the second face of the cover (400) and at least a portion of one of the electrodes (210, 230),
- a step of fixing a first end of at least one elongated electrical connection member (600) to an area of the connection pad (500) covering a portion of the second face of the cover (400),
**characterized in that** it comprises as further step
- the forming a layer of resist (700) covering the entire device; with said layer of resist (700) being so configured as to preserve an electrical access to a second end of the elongated electrical connection member (600) above the layer of resist (700).

2. A method according to the preceding claim, wherein the step of positioning the cover (400) is so configured as to preserve a space giving access to at least one of the electrodes (210, 230); with said cover (400) having at least one opening.

3. A method according to one of the preceding claims, wherein the step of positioning the cover (400) is so configured as to preserve a space giving access to at least a second electrode (210, 230); with said cover (400) having at least one second opening.

4. A method according to one of the preceding claims, wherein the step of positioning the cover (400), which creates at least two access spaces, is so configured as to frame the organic layer (220) while preserving the insulation thanks to the layer of resist (700).

5. A method according to one of the preceding claims, wherein the step fixing a first end of at least one elongated electrical connection member (600) comprises soldering and/or bonding.

6. A method according to one of the preceding claims, wherein the elongated electrical connection member (600) is an electrically conductive member having an elongated shape, selected from an electric wire, a metal leg or a pin.

7. A method according to one of the preceding claims, wherein the step of forming the connection pad (500) comprises a metallization and/or a vacuum deposition.

8. An organic light emitting device comprising a stack of layers (200) on a substrate (100), said stack comprising, successively, a first electrode (210), an organic layer (220), a second electrode (230), an adhesive layer (300), a cover (400) and a connection pad (500); with said connection pad (500) comprising a first portion parallel to the substrate (100), covering the area of the protruding part of one of the electrodes (210), (230), not covered, a second portion which extends over the edge along the thickness of the cover (400) and a third portion overlying a portion of the cover (400) face which is not covered by the adhesive layer (300), at least one elongated electrical connection member (600), one end of which is fixed to an area of the connection pad (500) covering a portion of the second cover (400)
**characterized in that** the device also comprises
- a layer of resist (700) covering the whole stack and filling the space(s) giving access to at least one of the electrodes (210), (230); with said layer of resist (700) being so configured as to preserve electrical access to a second end of at least one elongated electrical connection member (600) above the layer of resist (700).

9. A device according to the preceding claim, wherein the cover (400) has at least one opening preserving a space giving access to at least one of the electrodes (210,230).

10. A device according to one of the two preceding claims, wherein the cover (400) comprises at least one second opening preserving a space giving access to at least a second electrode (210, 230).

11. A device according to one of the two preceding claims, wherein the cover (400) has at least two access spaces filled with the layer of resist (700) making it possible to encapsulate and to protect the first electrode (210), the organic layer (220) and the second electrode (230).

12. A device according to one of the four preceding claims, wherein a first end of at least one elongated electrical connection member (600) is fixed by soldering or bonding on a portion of the connection pad (500).

13. A device according to one of the five preceding claims, wherein the elongated electrical connection member (600) is an electrically conductive member having an elongated shape selected from an electric wire, a metal leg or a pin.

14. A device according to one of the six preceding claims, wherein the connection pad (500) is made of a material selected from copper (Cu), aluminum (Al), silver (Ag), chromium (Cr), molybdenum (Mo), nickel (Ni), gold (Au).

15. A device according to claims 9 to 13, wherein the connection pad (500) comprises a two-layer stack of materials selected from the following combinations: copper/aluminum, copper/silver, copper/molybdenum, copper/chromium, copper/nickel, copper/gold and/or wherein the connection pad (500) comprises a two-layer stack of materials the layers of which are so configured as to be completely or partially superimposed.
